(19) Europäisches Patentamt
European Patent Office
Office européen des brevets

(11) **EP 3 685 506 B1**

(12) **EUROPEAN PATENT SPECIFICATION**

(45) Date of publication and mention
of the grant of the patent:
**06.03.2024 Bulletin 2024/10**

(21) Application number: **18723855.5**

(22) Date of filing: **17.05.2018**

(51) International Patent Classification (IPC):
**H03F 1/08** *(2006.01)* **H03F 3/08** *(2006.01)*
**H03F 1/02** *(2006.01)*

(52) Cooperative Patent Classification (CPC):
**H03F 1/086; H03F 1/0261; H03F 3/082;**
**H03F 3/087;** H03F 2200/129; H03F 2200/144;
H03F 2200/186; H03F 2200/24; H03F 2200/294;
H03F 2200/511; H03F 2200/516; H03F 2200/555;
H03F 2200/75

(86) International application number:
**PCT/EP2018/062918**

(87) International publication number:
**WO 2018/228772 (20.12.2018 Gazette 2018/51)**

(54) **A LOW-NOISE TRANSIMPEDANCE AMPLIFIER INCORPORATING A REGULATOR**

RAUSCHARMER TRANSIMPEDANZVERSTÄRKER MIT REGLER

AMPLIFICATEUR DE TRANSIMPÉDANCE À FAIBLE BRUIT INCORPORANT UN RÉGULATEUR

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **13.06.2017 EP 17175772**

(43) Date of publication of application:
**29.07.2020 Bulletin 2020/31**

(73) Proprietor: **Firecomms Limited
Cork (IE)**

(72) Inventors:
• **DONOVAN, Colm
Leap
County Cork (IE)**
• **CAHILL, Ciaran
Blarney
County Cork (IE)**

• **MURPHY, Patrick
Douglas
Cork (IE)**

(74) Representative: **Weldon O'Brien Ltd.
Shannon Lodge
Casement Road
Bandon
County Cork, P72 TN24 (IE)**

(56) References cited:
**WO-A1-2016/137768   US-A- 4 564 818
US-A1- 2008 174 372   US-A1- 2012 001 690
US-A1- 2013 271 218   US-A1- 2013 343 471
US-A1- 2014 132 342   US-A1- 2015 034 806
US-A1- 2017 026 011   US-B1- 6 476 678**

**Description**

INTRODUCTION

Field of the Invention

The invention relates to a low-noise transimpedance amplifier circuit, particularly for use with photodiodes in high speed digital communications applications.

Prior Art Discussion

In many digital communications applications using an optical transmission link a transimpedance amplifier (TIA) is used to convert the current generated by a photodiode to a voltage that can be processed and converted to digital data. Desirable properties of a TIA include high bandwidth, low input impedance, low noise, and additionally, an ability to control the bias voltage on the input photodiode.

An important consideration in modem integrated circuit TIAs for use with optical systems is the integration of the photodiode on the same substrate as the TIA. This results in a receiver that is more robust to interference and easier to manufacture. However, the fabrication process to integrate the photodiode has trade-offs which result in a relatively lower bandwidth photodiode. This fabrication process may also limit the electrical connections to the photodiode. A typical integrated photodiode anode may be formed by the substrate on a silicon wafer, wherein the substrate must connect to the lowest voltage supply, removing any option of a different electrical connection for the photodiode anode.

The bandwidth of a typical photodiode is highly dependent on its reverse bias voltage, in which the greater the reverse bias voltage, the higher the photodiode bandwidth. A severe limitation with many TIA architectures is the lack of control over the reverse bias of the photodiode.

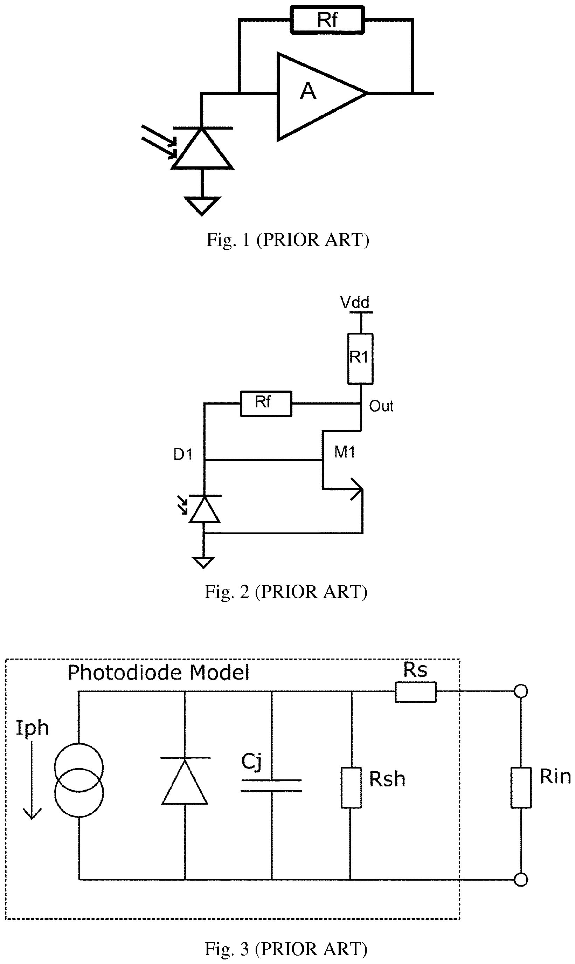

The photodiode bandwidth is also influenced by the input impedance presented to it when coupled to a TIA. The lower the input impedance presented to the photodiode, the faster the photodiode response, due to the lower RC constant of the photodiode capacitance and the input impedance. For example, in the simplified TIA circuit of Fig. 1 the input impedance presented to the photodiode is equal to the value of the transimpedance gain resistor (Rf) divided by the amplifier gain. Generally, the larger the transimpedance gain of the TIA, the better the signal-to-noise ratio. Therefore, a large transimpedance gain combined with a large amplifier gain is desirable, while at the same time maintaining adequate amplifier bandwidth, and providing a large reverse bias voltage for the photodiode.

A common TIA circuit is shown in Fig. 2, with a simple common source amplifier consisting of an NMOS transistor M1 with a resistor load R1, and a transimpedance resistor Rf connected between the amplifier input (the gate of M1) and output (the drain of M1) nodes.

One of the key limitations of the bandwidth of an optical receiver is the bandwidth of the photodiode. A photodiode is essentially a P-N junction. A P-N junction naturally develops a depletion region, and this depletion region size can be modulated with a reverse bias voltage.

Fig. 3 shows a model of a photodiode. Iph represents the photon generated current and is proportional to the light on the photodiode. Rsh represents the dark current I-V curve. Rs is the series resistance and is due to the combination of the contact resistance and the resistance of the undepleted diode regions. The wider the depletion region due to the reverse bias the lower the value of Rs. Cj is the junction capacitance of the depletion region. The wider the depletion region due to reverse bias the lower the value of Cj. Rin represents the input impedance of a TIA connected to the photodiode.

The bandwidth of the photodiode depends on three time constants; $T_{drift}$, $T_{diffusion}$, and $T_{RC}$. $T_{drift}$ is the time required for generated carriers to be swept out of the depletion region, and is inversely proportional to the applied reverse bias voltage up to a point at which the velocity saturates. $T_{diffusion}$ is a slower process that occurs to carriers generated outside of the depletion region creating a diffusion current. In the high-speed application of the present invention $T_{diffusion}$ can rendered of low importance through fabrication processes that remove most of the diffusion current from the signal current. $T_{RC}$ is the RC time constant created by Cj, the junction capacitance, Cpar, the parasitic capacitances such as that of wires and the TIA input capacitance, and the combination of Rs and Rin:

$$T_{RC} = (Cj + Cpar) * (Rs + Rin)$$

Three of the variables, Cj, Rs, and Rin depend on either the photodiode reverse bias voltage or the TIA input impedance. This demonstrates the importance of controlling the photodiode reverse bias voltage as well as the TIA input impedance when designing an optical receiver. To increase the bandwidth of an optical receiver the photodiode reverse-bias voltage may be increased or the TIA input impedance may be reduced. The input impedance may be reduced by increasing the gain of the amplifier in the TIA or by reducing the transimpedance resistor value Rf. For a better signal to noise ratio Rf would remain large and the gain of the amplifier would increase while maintaining bandwidth. A well-known technique for achieving high gain and high bandwidth is the cascading of amplifier stages, demonstrated in [1] p125.

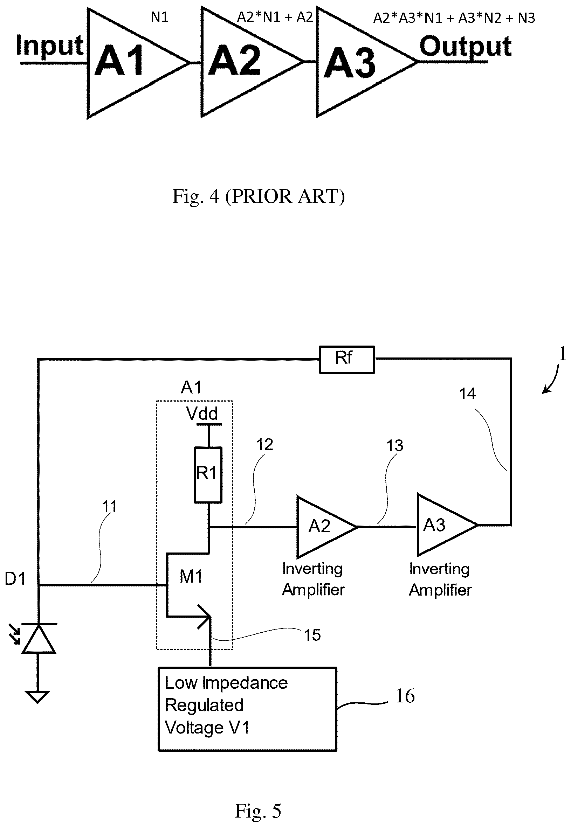

In addition to bandwidth, another important factor in TIA design is the circuit noise, and in particular the signal-to-noise ratio (SNR). The optimization of SNR in the amplifier is critical to the sensitivity of the receiver. Referring to Fig. 4, if we assume that all amplifiers A1/2/3 contribute noise (N1, N2, N3 respectively) on their own at their outputs, and the input noise is negligible, then the final noise output:

$$Nout = A2*A3*N1 + A3*N2 + N3$$

If as a simple example, we assume A1=A2=A3=10:

$$Nout = 100*N1 + 10*N2 + N3$$

This demonstrates that optimising the first stage amplifier SNR is critical.

One of the best amplifier circuits for good SNR is a common source amplifier with a resistive load. While extra gain can be achieved with a current mirror load in such an amplifier, the introduction of a current mirror can introduce additional noise and result in a worse SNR, although that would not preclude such an amplifier from functioning in the present invention.

The simple amplifier circuit in Fig. 2 is a low noise amplifier. However, it is difficult to achieve high gain with this amplifier together with high bandwidth, and therefore this architecture can result in a relatively high input impedance to a photodiode [1] p107. Additionally, it fails to provide a high bias voltage to the photodiode, the voltage on D1 being equal to the gate-source voltage of transistor M1.

An approach described in [2] involves the use of three cascaded common-source MOS amplification stages with current source loads to create an overall TIA. The second stage amplifier is described as a TIA, and is an inverting amplification stage with a resistor between its input and its output.

An approach described in [3] also uses three cascaded inverting amplifiers, in this case a first inverter amplifier with shunt feedback, a second inverter amplifier, and a third inverter amplifier with shunt feedback.

An approach described in [4] is a general case of that in [2], which uses the concept of "nested TIAs" to increase gain-bandwidth. It is important to note that increasing gain-bandwidth is not necessarily desirable if it is done at the expense of the signal-to-noise ratio.

Another three-stage amplifier is shown in [5].

A circuit described in [6] has a TIA amplifier, followed by a differential voltage amplifier. The TIA uses a reference voltage on the emitter of the input transistor to set the bias on the photodiode and has a single gain stage.

The present invention is directed towards providing a TIA which has control over the reverse bias on the photodiode, and/or which provides high-amplifier gain, and/or low-noise, and/or high-bandwidth.

References

[1]

    Title:    Design of Integrated Circuits for Optical Communications - second edition.
    Author:   Behzad Razavi, pages 107, 125.

[2]

    Title:    Amplifier Circuit, And System Incorporating Same
    Patent:   US 7265632 B2, Sep 4 2007
    Inventors:  Hock Tiong Kwa et al.
    Assignee:  Avago Technologies

[3]

Title:        High Gain, High Bandwidth CMOS Transimpedance Amplifier
Patent:       US6828857 B2, Dec 7 2007
Author:       Fabrice Pailler et al.
Assignee:     Intel Corporation, Santa Clara, CA

[4]

Title:        Nested Transimpedance Amplifier
Patent:       US6836182 B1, Dec 28 2004
Author:       Sehat Sutardja
Assignee:     Marvell International Ltd

[5]

Title:        Transimpedance Amplifier and Light Receiving Circuit
Patent:       US8674770 B2, Mar 18, 2014
Author:       Yukiko Takiba et al
Assignee:     Kabushiki Kaisha Toshiba

[6]

Title:        Advanced CMOS and BiCMOS photonic receiver ICs
Authors:      K. Kieschnick ; T. Heide ; A. Ghazi ; H. Zimmermann ; P. Seegebrecht
Published in: Solid-State Circuits Conference, 1999. ESSCIRC '99. Proceedings of the 25th European Solid-State Circuits Conference, 21-23 Sept. 1999, Pages 398-401

US2013271218 (TM Technology Inc) describes a high speed TIA with gain inventing units.
US2017026011 (Mindspeed Technologies, Inc.) describes a TIA with a bandwidth extender.
US2015034806 (Zhou, et al) describes a feedback-based trans-impedance amplifier with programmable input impedance. US2014132342 (NF Corporation) describes an amplifier circuit whose frequency response has almost no soft knee characteristic. US4564818 (Motorola Inc.) describes a TIA having an improved gain/bandwidth product.

Summary of the Invention

The invention provides an optical receiver as set out in claim 1.
Other embodiments are set out in claims 2 to 11.

Detailed Description of the Invention

The invention will be more clearly understood from the following description of some embodiments thereof, given by way of example only with reference to the accompanying drawings in which: -

Figs. 1, 2, 3, and 4 are diagrams illustrating aspects of the prior art as set out above, in which Fig. 1 is a generalised view of a photodiode (PD) and its connection to a TIA, Fig. 2 is a diagram illustrating a common source approach, Fig. 3 is a diagram showing a model of a photodiode, and Fig. 4 shows a simplified noise model of a three-stage amplifier;

Fig. 5 is a diagram showing an optical receiver not within the scope of the invention having a TIA with three inverting amplifier stages, and a low impedance regulated voltage source linked with the first stage;

Fig. 6 is a diagram showing an optical receiver of the invention having a TIA with three inverting amplifier stages, and a separate low impedance regulated voltage source linked with each stage;

Fig. 7 shows a further receiver, in this case with a PMOS transistor;

Fig. 8 shows a further receiver, not within the scope of the invention, in this case with five inverting amplifier stages, and a low impedance regulated voltage source linked with the first one;

Fig. 9 is a diagram showing an optical receiver having three inverting amplifier stages, and a first low impedance regulated voltage V1 linked to the first stage and a common low impedance regulated voltage V2 linked with the second and third stages;

Fig. 10 shows a differential optical receiver in which a photodiode D1 receives the light input signal and a photodiode D2 serves as a reference input; and

Fig. 11 is a diagram showing an optical receiver having three inverting amplifier stages, and a first low impedance regulated voltage V1 linked to the first stage and a common low impedance regulated voltage V2 linked with the second and stages; and the third stage source is connected to ground.

Description of the Embodiments

A transimpedance amplifier (TIA) circuit has an input terminal, an output terminal, an odd number of inverting amplifier stages linked in series between these terminals. At least the first stage has a transistor with a source, gate and a drain with a load circuit connected to the drain.

Preferably, the input of the first stage is the gate of the transistor, and the output of the first stage is coupled from the drain.

It should be clear to one skilled in the art that there are many forms of transistors, and in this specification when the terms source or drain or gate are used then their equivalents for other transistors can be assumed to also be valid, such as emitter, collector and base in the case of a bipolar transistor. Similarly, to one skilled in the art, a circuit that simply swaps PMOS and NMOS and/or polarities from a previous circuit is a simple and obvious modification to a circuit.

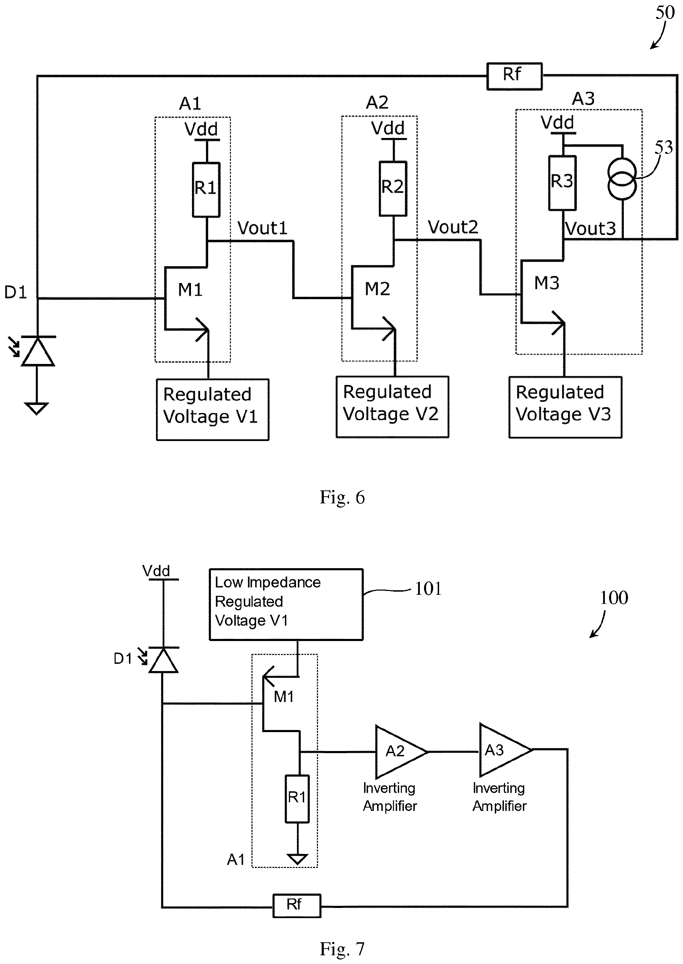

There is a reference voltage source connected to the source of the transistor of at least the first stage, and a transimpedance feedback circuit coupled between the output of the final stage and the input terminal. The second and subsequent stages are preferably common-source inverting amplifier stages (Fig. 6) but may also be amplifiers of another configuration (Fig. 5) (e.g. common-gate, common-drain, transimpedance amplifier, etc.). There may be a separate reference voltage source connected to the source of each stage, or two or more may have a common reference voltage source.

An optical receiver is shown in Fig. 5, in which an optical receiver 1 has three cascaded amplifiers A1, A2, and A3. The output of A1 is connected by a conductor 12 to the input of A2, and the output of A2 is connected by a conductor 13 to the input of A3. The output of A3 is connected to the input through a conductor 14 and a transimpedance resistor Rf. A photodiode D1 has its cathode connected by a link 11 to the receiver 1 input, and has its anode connected to ground. A variation may have the anode connected to a voltage other than ground, or in the case of Fig. 7 the cathode may be connected to a voltage other than Vdd.

The amplifier A1 comprises a common source transistor M1 and a load resistor R1 between M1 and the rail Vdd.

A low impedance regulated voltage 16 is connected by a link 15 to the source of the transistor M1. The reference voltage source is nominally constant, i.e. it is a DC voltage, and so is preferably provided by a regulator with low output impedance.

In an embodiment of the invention, Fig. 6 shows a receiver 50 in which there are again three inverting amplifiers A1, A2, and A3, but in this case there is a low impedance regulated voltage V1, V2, and V3 linked to each transistor M1, M2, and M3 respectively at the source of each common-source amplifier. A current mirror 53 is connected between the drain of M3 and Vdd for the purposes of providing a full range output for the amplifier. Without the current mirror 53 the current through R3 would approach zero as the voltage output Vout3 approaches the value of Vdd. However, with the current mirror 53 a current remains available to maintain correct operation of the amplifier A3 even as the output voltage Vout3 approaches Vdd.

A key benefit of this invention is that reverse bias voltage on D1 ($V_{DIODE}$) can be controlled through selection or programming of V1 while maintaining the low-noise common-source architecture in the first stage A1. This is due to the relationship:

$$V_{DIODE} = V_{GS1} + V1$$

for the first inverting amplifier, A1.

This solves a key limitation of prior TIA architectures.

The voltage gain, Av of a common source amplifier with a drain impedance $R_D$ and a transconductance Gm, and a source impedance of $R_{Sc}$ may be represented with the following simplified equation:

$$Av = -(Gm*R_D) / (1+Gm*R_{Sc}) ; \qquad (I)$$

The reference voltage source impedance, represented by $R_{Sc}$, reduces the voltage gain of the common-source amplifier, and in an ideal voltage source there would be zero source impedance. It should be clear that $R_{Sc}$ needs to be minimised to maximise the gain. Thus, even neglecting the noise contribution of $R_{Sc}$, it follows that $R_{Sc}$ needs to be minimised to maximise the signal gain, and thus maximise the signal-to-noise ratio. As already mentioned, maximising the signal-to-noise ratio at the 1st stage amplifier is critical to optimise receiver sensitivity.

If the voltage source is low impedance and renders the term (Gm* $R_{Sc}$ << 1) then the gain can be simplified to:

$$Av = -(Gm*R_D)$$

Continuing to refer to Fig. 6, and assuming for simplicity no current flowing in D1, the DC bias voltage at the output of A1 is:

$$V_{OUT1} = V_{DS1} + V1$$

Without the addition of V2, that is if the source of M2 were connected to ground, then

$$V_{GS2} = V_{OUT1} = V_{DS1} + V1$$

This means that $V_{GS2}$ would be very dependent on V1 for the Fig. 5 example. Additionally, the drain-source bias current in M1 ($I_{DSM1}$) is dependent on $V_{OUT1}$:

$$I_{DSM1} = (V_{DD} - V_{OUT1}) / R_1$$

Because of the dependence of this relationship on the voltage V1, the value of V1 chosen to optimise the voltage of D1, could compromise the gain and/or noise performance of A1, A2 and A3. In the embodiment of Fig. 6 the reference voltage source V2 allows the freedom to optimize the amplifier A2 to the most suitable $V_{GS2}$ so that now:

$$V_{GS2} = V_{DS1} + V1 - V2$$

Similarly, with A3:

$$V_{GS3} = V_{DS2} + V2 - V3$$

The parameters of the regulated voltages V1 are such that it may be at a minimum zero volts, although negative voltages in other embodiments may be possible, and a maximum of Vdd - $V_{GS1}$. Its value is preferably chosen such that an adequate reverse bias develops across the photodiode, and enough voltage headroom remains so that the TIA may operate. For example, a typical Vdd for integrated circuits is 3.3V. A photodiode of a certain size may require for example, a reverse bias of 2V for a bandwidth of 1GHz for a 1GHz receiver. A typical Vgs of an NMOS transistor could be estimated at 800mV. This would therefore necessitate a reference voltage of value 1.2V on the source of A1.

Furthermore, to optimise the signal-to-noise ratio of A1, the reference voltage source could be for example, a regulated voltage, with an impedance such that Gm1*$R_{Sc}$ is much less than 1. If M1 is biased such that its transconductance, Gm1, is equal to 1 millisiemen, then an impedance of 20 Ohms or less for the regulated voltage would result in Gm1* Rsc of 0.01 or less, reducing the A1 gain term of Gm1*Rd by no more than 1.01.

It is important to recognize that impedance is frequency dependent, and that the range of frequencies for which this this regulator must satisfy this criteria in this example would approximately be up to the 1 GHz operating frequency of the receiver. The DC impedance of the reference voltage source can be critical in applications where the amplifier must potentially function from DC up to high frequencies. Achieving this low impedance across a wide range of frequencies is a significant design challenge, especially for large values of Gm. In particular this is a challenge in integrated circuits which cannot take advantage of large area capacitors, and therefore simple passive solutions such as diode references with decoupling capacitors are not a feasible option. A voltage regulator, in contrast, consists of active amplification circuitry to create a stable output voltage with low output impedance over a range of frequencies, limited by the performance of the regulator. The amplification circuitry plays an important role in reducing the output impedance of the regulator.

If V2 is now chosen to satisfy:

$$V_{GS2} = V_{DS1} + V1 - V2$$

then for example, assuming a $V_{GS2}$ of 800mV, and an optimal $V_{DS1}$ of 400mV for signal-to-noise, then V2 would equal 0.8V on the source of M2. One could then for simplicity of design use V2 on the source of M3 also. The input impedance of V2 would be less critical than that of V1, because as Fig. 4 demonstrates, the most important optimisation for signal-to-noise ratio is achieved in A1. However, as adequate cascaded gain is still a requirement to lower the input impedance, it is preferred that the input impedance of V2 remain relatively low (such that Gm*$R_{Sc}$ < 1) throughout the frequencies of operation, for example, less than 100-ohms for a Gm of approximately 1mS.

Fig. 7 shows a receiver 100 in which there is a low impedance voltage source 101 linked with the source of a PMOS transistor M1 in a first inverting amplifier state stage.

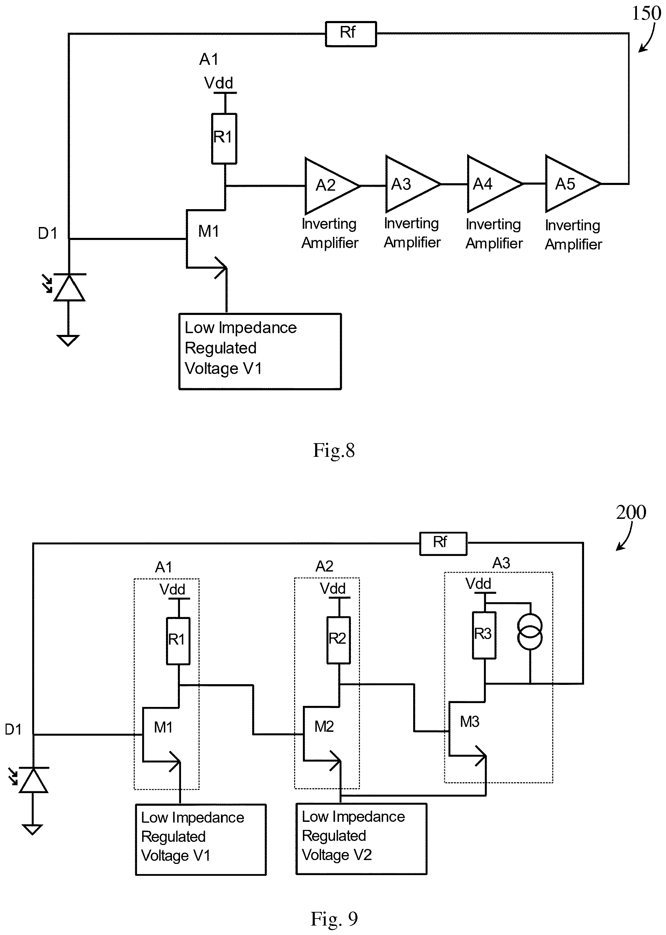

Fig. 8 shows a receiver 150 in which there are five inverting amplifiers A1, A2, A3, A4, and A5. In this case only the first inverting amplifier has a low impedance regulated voltage connected to its source, however, there may be one connected to one or more of the others, and some may be common. There is a feedback resistor Rf linking the output of A5 back to D1.

Where there are N inverting amplifiers it is feasible that the values of $V_{GS2}$ to $V_{GSN}$ are designed in such a way that V2 = V3 = ... = $V_N$, as shown in a receiver 200 of Fig. 9 in the case of 3 inverting amplifiers. In this case, a single reference voltage source could be used at the gate of both A2 and A3. This advantageously reduces the number of reference voltage sources, and it optimises A1 and A2, with A3 to $A_N$ being of less importance to optimise. As shown in Fig. 4, the first stage noise is the most important stage to optimise in terms of signal-to-noise ratio as it is amplified by the subsequent gain stages.

For example, in Fig. 6 it is possible that A1, A2, and A3 are designed in such a way that V1 = V2 = V3, in which case a single reference voltage source could supply all three stages of A1, A2, and A3.

The amplification stages could use either resistor loads or current source loads, or a combination of them. A current source would result in a lower SNR than a resistive load and is therefore not preferred, especially for A1.

The load may also be a transistor with its input gate connected to the gate of the input transistor to form a simple inverter amplifier. The load may also be a diode, or a diode connected transistor. The load may be another electrical circuit.

A current source load is especially beneficial in the final stage amplifier, as the output voltage at this amplifier could move close to the rail, which would turn off the current in a resistive load, and thus slew-limit the amplifier.

Non-inverting amplification stages may be placed after each, all, or any combination of, inverting amplifier stages, and this may improve drive capability of the stage.

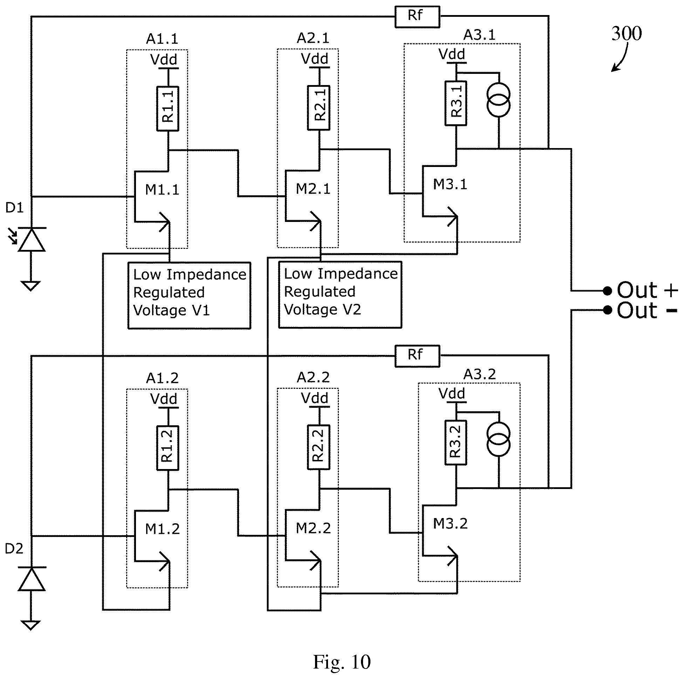

Fig. 10 shows a differential optical receiver in which a photodiode D1 receives the light input signal and a photodiode D2 serves as a reference input. Two identical TIAs provide a differential output signal. A differential receiver may advantageously provide a differential output with better common-mode rejection than a single-ended receiver. The differential TIAs could share reference voltage sources V1, V2, and/or V3. The differential TIAs could feed into another differential amplifier with the dual purpose of creating a fully differential output signal (with or without feedback), and also acting as an active filter so as to limit the signal bandwidth and improve SNR.

In alternative embodiments the reference voltage source need not be a fixed value over all circuit parameters. The reference may optimally vary with temperature or supply voltage to optimize the performance of the receiver over these conditions. Also, the reference voltage source may be programmable or otherwise adjustable by some other parameter, such as for example, the connection of an external resistor to the circuit, the value of this resistor being the parameter used to vary the voltage. However, for any given operating point the reference voltage source remains nominally constant and DC.

A benefit of cascading the amplifiers is that high gain and high bandwidth can be achieved. Non-inverting amplifiers or buffers may be present within the amplifiers A2 or A3 at their inputs or outputs.

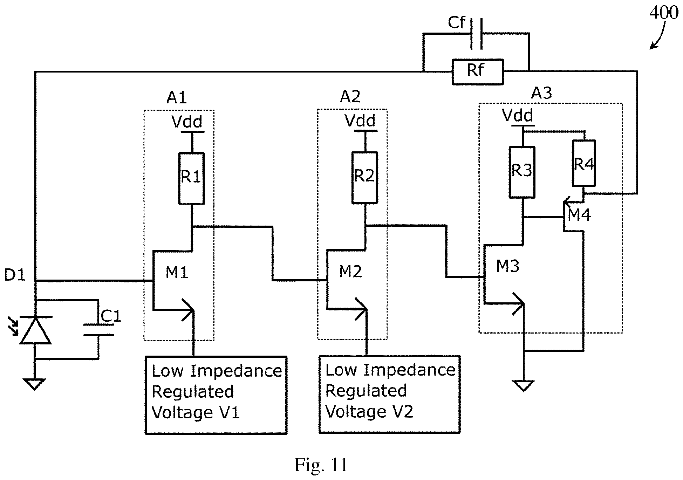

Fig. 11 is a diagram showing an optical receiver having three inverting amplifier stages, and a first low impedance regulated voltage V1 linked to the first stage and a common low impedance regulated voltage V2 linked with the second and stages; and the third stage source is connected to ground, and the third stage inverting transistor drain is coupled to its output through a non-inverting amplifier. The third stage inverting transistor drain is coupled to its output through a non-inverting amplifier. An input photodiode D1 is shown linked to the input. A feedback resistor Rf is shown linking the output of the amplifier to the input of the amplifier. A feedback capacitor Cf is shown in parallel with Rf. A stability capacitor C1 is shown in parallel with D1.

The receiver of Fig. 11 benefits from a buffer consisting of a PMOS follower transistor with a resistor load coupling the drain of the amplifier transistor M3 to the overall amplifier output. In terms of what is represented in the block diagrams, as the buffer circuit does not affect the polarity of the amplifier of M3 and its load, then the buffer is considered functionally part of A3 in any block diagram.

The amplifier transistor M1 could be substituted with a bipolar transistor to form a common emitter amplifier, and, depending on the process characteristics, provide an advantage over the MOS implementation.

The reference voltage source is preferably a voltage regulator with a low output impedance to optimize the amplification voltage gain term (I). A low-drop-out (LDO) voltage regulator is an option. Preferably, the output impedance of the reference voltage source should result in $Gm* R_{Sc} << 1$, where Gm is the transistor transconductance of the common source stage, and $R_{Sc}$ is the output impedance of the reference voltage source. The reference voltage source is preferably programmable to optimise the photodiode to a given bandwidth. The reference voltage source may advantageously have a proportionality to temperature to compensate for temperature effects on the photodiode bandwidth.

A feedback resistor (Rf) and/or an automatic gain circuit (AGC) may be employed.

Bipolar transistors may be used instead of MOS transistors in some embodiments.

PMOS transistors may be used instead of NMOS transistors in some embodiments.

The amplifier A3 may be an inverting amplifier stage other than a common-source amplifier in some embodiments.

In some embodiments, any uneven number of inverting amplifier stages greater than three may be used.

In one embodiment, a photodiode is integrated onto the same integrated circuit as the optical receiver.

The invention includes various transimpedance amplifier circuits with regulator(s), which uses cascaded amplification stages to achieve high gain, high bandwidth, high signal to noise ratio, and control over the input bias voltage.

The invention is not limited to the embodiments described but may be varied in construction and detail within the scope of the claims. For example, as shown in Fig. 11, a capacitance may be connected in parallel with the feedback resistor for stability. Similarly, as shown in Fig. 11, a capacitance (C1) may be connected in parallel with the photodiode (D1) to increase stability in some scenarios, at the expense of photodiode bandwidth. Also, in various examples, there may be an automatic gain control circuit for transimpedance gain control, and/or components for control of impedance of the amplifier loads for amplifier gain control and for stability, and/or non-inverting buffers between at least two stages. There may additionally be circuitry to enable programming of the output voltage of the reference voltage sources. In some embodiments the reference voltage source may have a dependence on a physical parameter, such as temperature or supply voltage, in order to optimise the circuit over various circuit conditions.

**Claims**

1. An optical receiver comprising a photodiode (D1) and a transimpedance amplifier, TIA, circuit both integrated onto an integrated circuit, and comprising an input terminal (11) and an output terminal (14), a ground, and a rail Vdd, and the TIA further comprising: an odd number of at least three inverting amplifier stages (A1, A2, A3, A4, A5) linked in series between the input terminal and the output terminal, said inverting amplifier stages including a first inverting amplifier stage (A1) having an input connected to the input terminal (11), a second inverting amplifier stage (A2), and a final inverting amplifier stage having an output connected to the output terminal, and the first and second inverting amplifier stages each having a MOS transistor (M1, M2) with a source, a gate, a drain or a bipolar transistor with an emitter, a base, and a collector and a load circuit (R1, R2) connected to the drain or collector,

   wherein said load circuit is either a resistor load or a current source load or a combination of a resistor load and a current source load,
   wherein the input (11) of said first inverting amplifier stage (A1) is the gate or base of the transistor (M1) of said first inverting amplifier stage, and the output (12) of said first inverting amplifier stage is the drain or collector of the transistor of said first inverting amplifier stage,
   wherein the input (12) of said second inverting amplifier stage (A2) is the gate or base of the transistor (M2) of said second inverting amplifier stage, and the output (13) of said second inverting amplifier stage is the drain or collector of the transistor of said second inverting amplifier stage,
   a transimpedance feedback circuit coupled (Rf) between the output of the final inverting amplifier stage and the input terminal,
   wherein a first reference voltage source (V1) is connected to the source or emitter of the transistor (M1) of the first inverting amplifier stage (A1), and a second reference voltage source (V2) is connected to the source or emitter of the transistor (M2) of the second inverting amplifier stage (A2),

wherein said first and second reference voltage sources each comprises a voltage regulator, and either:

the anode of said photodiode (D1) is connected to ground and its cathode is connected to the input terminal (11) and the first and second inverting stage amplifier transistors (M1, M2) are NMOS or NPN transistors, or:

the cathode of said photodiode (D1) is connected to the rail Vdd and its anode is connected to the input terminal (11) and the first and second inverting stage amplifier transistors (M1, M2) are PMOS or PNP transistors.

2. An optical receiver as claimed in claim 1, wherein there are three inverting amplifier stages (A1, A2, A3) in which a third inverting amplifier stage has a MOS transistor (M3) with a source, a gate, a drain or a bipolar transistor with an emitter, a base, and a collector and a load circuit (R3, 53) connected to the drain or collector,

wherein said load circuit is either a resistor load or a current source load or a combination of a resistor load and a current source load,

wherein the input of said third inverting amplifier stage (A3) is the gate or base of the transistor (M3) of said third inverting amplifier stage, and the output of said third inverting amplifier stage is the drain or collector of the transistor of said third inverting amplifier stage and is connected to said output terminal (14),and

said second reference voltage source (V2) is connected to the source or emitter of the transistor (M3) of the third inverting amplifier stage (A3).

3. An optical receiver as claimed in claim 1, wherein there are three inverting amplifier stages (A1, A2, A3) in which a third inverting amplifier stage has a MOS transistor (M3) with a source, a gate, a drain or a bipolar transistor with an emitter, a base, and a collector and a load circuit (R3, 53) connected to the drain or collector,

wherein said load circuit is either a resistor load or a current source load or a combination of a resistor load and a current source load,

wherein the input of said third inverting amplifier stage (A3) is the gate or base of the transistor (M3) of said third inverting amplifier stage, and the output of said third inverting amplifier stage is the drain or collector of the transistor of said third inverting amplifier stage and is connected to said output terminal (14), and

and a third reference voltage source (V3) is connected to the source or emitter of the transistor (M3) of the third inverting amplifier stage (A3).

4. An optical receiver as claimed in any preceding claim, wherein at least one reference voltage source is programmable.

5. An optical receiver as claimed in any preceding claim, wherein each reference voltage source has an impedance with a range set by a relationship in which $Gm * R_{Sc} < 1$, where Gm is the transconductance of the first inverting amplifier stage transistor (M1), and $R_{Sc}$ is the output impedance of the reference voltage source (V1) connected to the source or emitter of the first inverting amplifier stage transistor (M1).

6. An optical receiver wherein the optical receiver is a differential optical receiver comprising a first optical receiver in accordance with any preceding claim, and a second optical receiver in accordance with any preceding claim, to provide differential signal processing, and wherein the input terminals of the first and second optical receivers form a differential input and the output terminals of said first and second optical receivers form a differential output.

7. An optical receiver as claimed in any preceding claim, wherein the load of at least one inverting amplifier stage includes a current source (53).

8. An optical receiver as claimed in any preceding claim, wherein the load of at least the first inverting amplifier stage includes a resistor.

9. An optical receiver as claimed in any preceding claim, further comprising:
an automatic gain control circuit for gain control of the transimpedance feedback circuit.

10. An optical receiver (400) as claimed in any preceding claim, further comprising a non-inverting buffer (M4, R4) before or after any inverting amplifier stage.

11. An optical receiver as claimed in any preceding claim, in which at least one of the inverting amplifier stages comprises a transimpedance amplifier.

**Patentansprüche**

1. Optischer Empfänger, umfassend eine Fotodiode (D1) und einen Transimpedanzverstärker(Transimpedance Amplifier, TIA)-Kreis, die beide zu einer integrierten Schaltung integriert sind, und umfassend einen Eingangsanschluss(11) und einen Ausgangsanschluss (14), eine Masse und eine Rail-Vdd und wobei der TIA ferner Folgendes umfasst: ein ungerade Anzahl von mindestens drei invertierenden Verstärkerstufen (A1, A2, A3, A4, A5), die zwischen dem Eingangsanschluss und dem Ausgangsanschluss in Reihe geschaltet sind, wobei die invertierenden Verstärkerstufen eine erste invertierende Verstärkerstufe (A1) mit einem mit dem Eingangsanschluss (11) verbundenen Eingang, eine zweite invertierende Verstärkerstufe (A2) und eine letzte invertierende Verstärkerstufe mit einem mit dem Ausgangsanschluss verbundenen Ausgang umfassen und die erste und die zweite invertierende Verstärkerstufe jeweils einen MOS-Transistor (M1, M2) mit einer Source, einem Gate, einem Drain oder einen Bipolartransistor mit einem Emitter, einer Basis und einem Kollektor und einen mit dem Drain oder dem Kollektor verbundenen Lastkreis (R1, R2) aufweisen,

wobei der Lastkreis entweder eine Widerstandslast oder eine Stromquellenlast oder eine Kombination aus einer Widerstandslast und einer Stromquellenlast ist,
wobei der Eingang (11) der ersten invertierenden Verstärkerstufe (A1) das Gate oder die Basis des Transistors (M1) der ersten invertierenden Verstärkerstufe ist und der Ausgang (12) der ersten invertierenden Verstärkerstufe der Drain oder der Kollektor des Transistors der ersten invertierenden Verstärkerstufe ist,
wobei der Eingang (12) der zweiten invertierenden Verstärkerstufe (A2) das Gate oder die Basis des Transistors (M2) der zweiten invertierenden Verstärkerstufe ist und der Ausgang (13) der zweiten invertierenden Verstärkerstufe der Drain oder der Kollektor des Transistors der zweiten invertierenden Verstärkerstufe ist,
einen Transimpedanz-Rückkopplungskreis (Rf), der zwischen den Ausgang der letzten invertierenden Verstärkerstufe und den Eingangsanschluss gekoppelt ist, wobei
eine erste Bezugsspannungsquelle (V1) mit der Source oder dem Emitter des Transistors (M1) der ersten invertierenden Verstärkerstufe (A1) verbunden ist und eine zweite Bezugsspannungsquelle (V2) mit der Source oder dem Emitter des Transistors (M2) der zweiten invertierenden Verstärkerstufe (A2) verbunden ist,
wobei die erste und die zweite Bezugsspannungsquelle jeweils einen Spannungsregler umfassen,
und wobei entweder
die Anode der Fotodiode (D1) mit Masse verbunden ist und ihre Kathode mit dem Eingangsanschluss (11) verbunden ist und die Transistoren (M1, M2) der ersten und der zweiten invertierenden Verstärkerstufe NMOS- oder NPN-Transistoren sind,
oder
die Kathode der Fotodiode (D1) mit der Rail-Vdd verbunden ist und ihre Anode mit dem Eingangsanschluss (11) verbunden ist und die Transistoren (M1, M2) der ersten und der zweiten invertierenden Verstärkerstufe PMOS- oder PNP-Transistoren sind.

2. Optischer Empfänger nach Anspruch 1, wobei drei invertierende Verstärkerstufen (A1, A2, A3) vorhanden sind, wobei eine dritte invertierende Verstärkerstufe einen MOS-Transistor (M3) mit einer Source, einem Gate, einem Drain oder einen Bipolartransistor mit einem Emitter, einer Basis und einem Kollektor und einen mit dem Drain oder dem Kollektor verbundenen Lastkreis (R3, 53) aufweist,

wobei der Lastkreis entweder eine Widerstandslast oder eine Stromquellenlast oder eine Kombination aus einer Widerstandslast und einer Stromquellenlast ist,
wobei der Eingang (11) der dritten invertierenden Verstärkerstufe (A3) das Gate oder die Basis des Transistors (M3) der dritten invertierenden Verstärkerstufe ist und der Ausgang der dritten invertierenden Verstärkerstufe der Drain oder der Kollektor des Transistors der dritten invertierenden Verstärkerstufe ist und mit dem Ausgangsanschluss (14) verbunden ist, und
die zweite Bezugsspannungsquelle (V2) mit der Source oder dem Emitter des Transistors (M3) der dritten invertierenden Verstärkerstufe (A3) verbunden ist.

3. Optischer Empfänger nach Anspruch 1, wobei drei invertierende Verstärkerstufen (A1, A2, A3) vorhanden sind, wobei eine dritte invertierende Verstärkerstufe einen MOS-Transistor (M3) mit einer Source, einem Gate, einem Drain oder einen Bipolartransistor mit einem Emitter, einer Basis und einem Kollektor und einen mit dem Drain oder dem Kollektor verbundenen Lastkreis (R3, 53) aufweist,

> wobei der Lastkreis entweder eine Widerstandslast oder eine Stromquellenlast oder eine Kombination aus einer Widerstandslast und einer Stromquellenlast ist,
> wobei der Eingang der dritten invertierenden Verstärkerstufe (A3) das Gate oder die Basis des Transistors (M3) der dritten invertierenden Verstärkerstufe ist und der Ausgang der dritten invertierenden Verstärkerstufe der Drain oder der Kollektor des Transistors der dritten invertierenden Verstärkerstufe ist und mit dem Ausgangsanschluss (14) verbunden ist, und
> und eine dritte Bezugsspannungsquelle (V3) mit der Source oder dem Emitter des Transistors (M3) der dritten invertierenden Verstärkerstufe (A3) verbunden ist.

4. Optischer Empfänger nach einem der vorangehenden Ansprüche, wobei mindestens eine Bezugsspannungsquelle programmierbar ist.

5. Optischer Empfänger nach einem der vorangehenden Ansprüche, wobei die Bezugsspannungsquellen jeweils eine Impedanz mit einem Bereich aufweisen, der durch eine Beziehung festgelegt ist, in der Gm*$R_{Sc}$ < 1, wobei Gm die Transkonduktanz des Transistors (M1) der ersten invertierenden Verstärkerstufe ist und $R_{Sc}$ die Ausgangsimpendanz der mit der Source oder dem Emitter des Transistors (M1) der ersten invertierenden Verstärkerstufe verbundenen Bezugsspannungsquelle (V1) ist.

6. Optischer Empfänger, wobei der optische Empfänger ein optischer Differenzempfänger ist, der einen ersten optischen Empfänger gemäß einem der vorangehenden Ansprüche und einen zweiten optischen Empfänger gemäß einem der vorangehenden Ansprüche umfasst, um Differenzsignalverarbeitung bereitzustellen, und wobei die Eingangsanschlüsse des ersten und des zweiten optischen Empfängers einen Differenzeingang bilden und die Ausgangsanschlüsse des ersten und des zweiten optischen Empfängers einen Differenzausgang bilden.

7. Optischer Empfänger nach einem der vorangehenden Ansprüche, wobei die Last mindestens einer invertierenden Verstärkerstufe eine Stromquelle (53) umfasst.

8. Optischer Empfänger nach einem der vorangehenden Ansprüche, wobei die Last mindestens der ersten invertierenden Verstärkerstufe einen Widerstand umfasst.

9. Optischer Empfänger nach einem der vorangehenden Ansprüche, ferner umfassend:
einen automatischen Verstärkungsregelkreis zur Verstärkungsregelung des Transimpedanz-Rückkopplungskreises.

10. Optischer Empfänger (400) nach einem der vorangehenden Ansprüche, ferner umfassend einen nicht invertierenden Puffer (M4, R4) vor oder hinter einer beliebigen invertierenden Verstärkerstufe.

11. Optischer Empfänger nach einem der vorangehenden Ansprüche, wobei mindestens eine der invertierenden Verstärkerstufen einen Transimpedanzverstärker umfasst.

## Revendications

1. Récepteur optique comprenant une photodiode (D1) et un circuit d'amplificateur à transimpédance, TIA, tous deux intégrés sur un circuit intégré, et comprenant une borne d'entrée (11) et une borne de sortie (14), une masse, et une Vdd de rail, et le TIA comprenant en outre : un nombre impair d'au moins trois étages d'amplificateur d'inversion (A1, A2, A3, A4, A5) reliés en série entre la borne d'entrée et la borne de sortie, lesdits étages d'amplificateur d'inversion incluant un premier étage d'amplificateur d'inversion (A1) dont une entrée est connectée à la borne d'entrée (11), un deuxième étage d'amplificateur d'inversion (A2), et un étage final d'amplificateur d'inversion dont une sortie est connectée à la borne de sortie, et les premier et deuxième étages d'amplificateur d'inversion ayant chacun un transistor MOS (M1, M2) doté d'une source, d'une grille, d'un drain ou un transistor bipolaire doté d'un émetteur, d'une base, et d'un collecteur et un circuit de charge (R1, R2) connecté au drain ou au collecteur,

> dans lequel ledit circuit de charge est soit une charge de résistance soit une charge de source de courant soit une combinaison d'une charge de résistance et d'une charge de source de courant,
> dans lequel l'entrée (11) dudit premier étage d'amplificateur d'inversion (A1) est la grille ou base du transistor (M1) dudit premier étage d'amplificateur d'inversion, et la sortie (12) dudit premier étage d'amplificateur d'inversion est le drain ou collecteur du transistor dudit premier étage d'amplificateur d'inversion,

dans lequel l'entrée (12) dudit deuxième étage d'amplificateur d'inversion (A2) est la grille ou base du transistor (M2) dudit deuxième étage d'amplificateur d'inversion, et la sortie (13) dudit deuxième étage d'amplificateur d'inversion est le drain ou collecteur du transistor dudit deuxième étage d'amplificateur d'inversion,

un circuit de rétroaction de transimpédance couplé (Rf) entre la sortie de l'étage final d'amplificateur d'inversion et la borne d'entrée,

dans lequel

une première source de tension de référence (V1) est connectée à la source ou l'émetteur du transistor (M1) du premier étage d'amplificateur d'inversion (A1), et une deuxième source de tension de référence (V2) est connectée à la source ou l'émetteur du transistor (M2) du deuxième étage d'amplificateur d'inversion (A2), dans lequel les première et deuxième sources de tension de référence comprennent chacune un régulateur de tension, et soit :

l'anode de ladite photodiode (D1) est connectée à la masse et sa cathode est connectée à la borne d'entrée (11) et les transistors (M1, M2) des premier et deuxième étages d'amplificateur d'inversion sont des transistors NMOS ou NPN,

soit :

la cathode de ladite photodiode (D1) est connectée à la Vdd de rail et son anode est connectée à la borne d'entrée (11) et les transistors (M1, M2) des premier et deuxième étages d'amplificateur d'inversion sont des transistors PMOS ou PNP.

2. Récepteur optique selon la revendication 1, dans lequel il y a trois étages d'amplificateur d'inversion (A1, A2, A3) dans lesquels un troisième étage d'amplificateur d'inversion comporte un transistor MOS (M3) pourvu d'une source, d'une grille, d'un drain ou un transistor bipolaire pourvu d'un émetteur, d'une base et d'un collecteur et un circuit de charge (R3, 53) connecté au drain ou au collecteur,

dans lequel ledit circuit de charge est soit une charge de résistance soit une charge de source de courant soit une combinaison d'une charge de résistance et d'une charge de source de courant,

dans lequel l'entrée dudit troisième étage d'amplificateur d'inversion (A3) est la grille ou base du transistor (M3) dudit troisième étage d'amplificateur d'inversion, et la sortie dudit troisième étage d'amplificateur d'inversion est le drain ou collecteur du transistor dudit troisième étage d'amplificateur d'inversion et est connectée à ladite borne de sortie (14), et

ladite deuxième source de tension de référence (V2) est connectée à la source ou l'émetteur du transistor (M3) du troisième étage d'amplificateur d'inversion (A3).

3. Récepteur optique selon la revendication 1, dans lequel il y a trois étages d'amplificateur d'inversion (A1, A2, A3) dans lesquels un troisième étage d'amplificateur d'inversion comporte un transistor MOS (M3) pourvu d'une source, d'une grille, d'un drain ou un transistor bipolaire pourvu d'un émetteur, d'une base et d'un collecteur et un circuit de charge (R3, 53) connecté au drain ou au collecteur,

dans lequel ledit circuit de charge est soit une charge de résistance soit une charge de source de courant soit une combinaison d'une charge de résistance et d'une charge de source de courant,

dans lequel l'entrée dudit troisième étage d'amplificateur d'inversion (A3) est la grille ou base du transistor (M3) dudit troisième étage d'amplificateur d'inversion, et la sortie dudit troisième étage d'amplificateur d'inversion est le drain ou collecteur du transistor dudit troisième étage d'amplificateur d'inversion et est connectée à ladite borne de sortie (14), et

et une troisième source de tension de référence (V3) est connectée à la source ou l'émetteur du transistor (M3) du troisième étage d'amplificateur d'inversion (A3).

4. Récepteur optique selon l'une quelconque des revendications précédentes, dans lequel au moins une source de tension de référence est programmable.

5. Récepteur optique selon l'une quelconque des revendications précédentes, dans lequel chaque source de tension de référence a une impédance ayant une plage définie par une relation dans laquelle $Gm* R_{Sc} < 1$, où $Gm$ est la transconductance du transistor (M1) du premier étage d'amplificateur d'inversion, et $R_{Sc}$ est l'impédance de sortie de la source de tension de référence (V1) connectée à la source ou l'émetteur du transistor (M1) du premier étage d'amplificateur d'inversion.

**6.** Récepteur optique dans lequel le récepteur optique est un récepteur optique différentiel comprenant un premier récepteur optique selon l'une quelconque des revendications précédentes, et un second récepteur optique selon l'une quelconque des revendications précédentes, pour fournir un traitement de signal différentiel, et dans lequel les bornes d'entrée des premier et second récepteurs optiques forment une entrée différentielle et les bornes de sortie desdits premier et second récepteurs optiques forment une sortie différentielle.

**7.** Récepteur optique selon l'une quelconque des revendications précédentes, dans lequel la charge d'au moins un étage d'amplificateur d'inversion inclut une source de courant (53).

**8.** Récepteur optique selon l'une quelconque des revendications précédentes, dans lequel la charge d'au moins le premier étage d'amplificateur d'inversion inclut une résistance.

**9.** Récepteur optique selon l'une quelconque des revendications précédentes comprenant en outre :
un circuit de commande du gain automatique destiné à la commande du gain du circuit de rétroaction de transimpédance.

**10.** Récepteur optique (400) selon l'une quelconque des revendications précédentes, comprenant en outre un tampon non inverseur (M4, R4) avant ou après l'un quelconque des étages d'amplificateur d'inversion.

**11.** Récepteur optique selon l'une quelconque des revendications précédentes, dans lequel au moins l'un des étages d'amplificateur d'inversion comprend un amplificateur à transimpédance.

Fig. 1 (PRIOR ART)

Fig. 2 (PRIOR ART)

Fig. 3 (PRIOR ART)

N1    A2*N1 + A2    A2*A3*N1 + A3*N2 + N3

Input **A1**    **A2**    **A3** Output

Fig. 4 (PRIOR ART)

Rf

A1

Vdd

R1

12    13    14

11

D1

M1

A2    A3

Inverting    Inverting
Amplifier    Amplifier

15

Low Impedance
Regulated
Voltage V1

16

Fig. 5

50

A1

Vdd

R1

Vout1

D1

M1

Regulated
Voltage V1

A2

Vdd

R2

Vout2

M2

Regulated
Voltage V2

A3

Vdd

R3

53

Vout3

M3

Regulated
Voltage V3

Rf

Fig. 6

Vdd

Low Impedance
Regulated
Voltage V1

101

100

D1

M1

A2

Inverting
Amplifier

A3

Inverting
Amplifier

R1

A1

Rf

Fig. 7

150

A1
Vdd

Rf

R1

D1

M1

A2
Inverting
Amplifier

A3
Inverting
Amplifier

A4
Inverting
Amplifier

A5
Inverting
Amplifier

Low Impedance
Regulated
Voltage V1

Fig.8

200

Rf

A1
Vdd

A2
Vdd

A3
Vdd

R1

R2

R3

D1

M1

M2

M3

Low Impedance
Regulated
Voltage V1

Low Impedance
Regulated
Voltage V2

Fig. 9

Fig. 10

Fig. 11

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 7265632 B2
- US 6828857 B2
- US 6836182 B1
- US 8674770 B2
- US 2013271218 A
- US 2017026011 A
- US 2015034806 A, Zhou
- US 2014132342 A
- US 4564818 A

**Non-patent literature cited in the description**

- **K. KIESCHNICK ; T. HEIDE ; A. GHAZI ; H. ZIMMERMANN ; P. SEEGEBRECHT.** Advanced CMOS and BiCMOS photonic receiver ICs. *Solid-State Circuits Conference, 1999. ESSCIRC '99. Proceedings of the 25th European Solid-State Circuits Conference,* 21 September 1999, 398-401